Europäisches Patentamt

(19) European Patent Office

Office européen des brevets

(11) Publication number: **0 462 760 A2**

# (12) EUROPEAN PATENT APPLICATION

(21) Application number: 91305392.2

(22) Date of filing: 14.06.91

(51) Int. Cl.⁵: **G06F 15/72**

(30) Priority: 15.06.90 CA 2018929

(43) Date of publication of application:
27.12.91 Bulletin 91/52

(84) Designated Contracting States:
CH DE FR GB IT LI NL SE

(71) Applicant: International Business Machines
Corporation
Old Orchard Road
Armonk, N.Y. 10504 (US)

(72) Inventor: Arevalo Paul E.
10 Cricket Hollow
Thornhill, Ontario (CA)
Inventor: Umamaheswaran,
Vettakkorumakankavu S.
23 Leah Crescent
Ajax, Ontario (CA)

(74) Representative: Killgren, Neil Arthur
IBM United Kingdom Limited Intellectual
Property Department Hursley Park
Winchester Hampshire SO21 2JN (GB)

(54) Code page identification system.

(57) This disclosure relates to a comprehensive method of codifying the different encoding schemes that are used for graphic character representation, resulting in a single identification mechanism that is used in conjunction with a corresponding registry to simply and uniquely identify the scheme used. The mechanism comprises such a short form identifier having the capability of acting as a short form (alias) for its corresponding list of component identifiers; acting as a short form for a collection of specific component identifiers having a specific property; allowing special meanings to be conveyed in relation to tagging of data with the code identification; and allowing bridging to existing systems that use only some components of the code identification.

EP 0 462 760 A2

This invention is directed to the processing and interchange of coded, graphic character data.

Graphic character data is represented in computers as binary bit patterns or code points. Underlying each representation is a systematic method, an encoding scheme, that specifies the permissible bit patterns, and the rules for allocating these hit patterns to graphic characters and other characters.

With advances in the computer and telecommunication technologies, computers are used in an ever increasing variety of applications. To satisfy these applications, several different encoding schemes (for graphic character representation) have been developed and used in the industry. Some of the schemes are described in different international and national standards. Some examples are ISO 646, ISO 4873 and ISO 2022 from the International Organization for Standardization, CCITT ITA2 and CCITT T.61 from the Consultative Committee on International Telephone and Telegraph. Others are manufacturer or industry specific. Within hardware and software products of International Business Machines Corporation, several graphic character encoding schemes are used, such as EBCDIC, EBCDIC DBCS, PC EXTENDED ASCII, and DBCS MIXED (for the IBM personal computer). Further advances are expected to lead to newer schemes such as the "ISO Draft Proposed Standard On Multi-Octet Code" (ISO DP 10646).

A computer system typically uses one or more of these schemes to represent graphic character data and processes the data in that representation. When a computer system is used to serve a number of different applications that need different representations, it has to deal with the graphic character data represented using different schemes. Also, as computer system interconnections grow, graphic character data represented in different systems has to be interchanged. For example, the character "A" is encoded as X'41' within the IBM PC Extended ASCII scheme and is encoded as X'C1' within the IBM EBCDIC scheme. As long as such data is completely generated, processed and interchanged in systems that use a single encoding scheme, it is not necessary to identify the scheme used, other than in a descriptive manner in appropriate documentation. However, when heterogeneous systems that use different schemes interact with each other, it is necessary to identify the graphic character encoding scheme in a manner that can be interpreted in each system without any ambiguity.

In order to create the appropriate bit pattern that has been assigned to a graphic character and to be able to derive the graphic character that has been assigned to a binary bit pattern, it is necessary to be able to identify unambiguously the coded character set (called a code in subsequent references) that is used.

## DEFINITIONS

ENCODING SCHEME (ES) - a set of specific definitions that describe the philosophy used to represent character data. The number of bits, the number of bytes, the allocatable ranges of bytes, the maximum number of characters, and the meanings assigned to generic and specific bit patterns, are some examples of specifications to be found in such a definition.

ENCODING SCHEME IDENTIFIER (ESid) - a number assigned to uniquely identify a particular encoding scheme specifications.

ADDITIONAL CODING RELATED REQUIRED INFORMATION (ACRI) - information that may be required to complete the definitions association when using particular encoding schemes. An example is the range of valid first bytes of double byte code points in a personal computer mixed single-byte and double-byte code.

CODED CHARACTER SET IDENTIFIER (CCSid) - a 16 bit number identifying a specific set of encoding scheme identifier, character set identifier(s), code page identifier(s) and other relevant information that uniquely identifies the coded graphic character representations used.

CODE EXTENSION METHOD - a method prescribed in encoding schemes for representing characters that cannot be accommodated within the limits of the basic structure of the code. It is a method prescribed to alter the interpretation of one or more code points that follow a prescribed single control character or a control sequence.

IDENTIFIERS - for uniquely identifying graphic character representation CCSid is a short form identifier, the set of ESid, CSid, CPid and ACRI is a long form identifier.

CHARACTER SET - a defined set of characters, without coded representation.

CODE PAGE - a specification of code points for each graphic character in a set or in a collection of graphic character sets. Within a code page, a code point can have only one specific meaning.

A code is composed of a number of components, including:

\* An Encoding Scheme (ES) that lays out the coding space, rules of assignment, the number of bits per bit pattern, and any particular code extension mechanism that is used.

\* Depending on the encoding scheme, one or more pairs of the following:

  – A graphic Character Set (CS) which is a collection of valid graphic characters to be coded.

  – A Code Page (CP) which is an assignment of each graphic character in the set to a bit pattern following the encoding scheme rules.

* Additional Coding related Required Information (ACRI) that is needed to complete the definition of the code.

A computer system typically uses one or more of these codes to represent and process graphic character data. A computer system serving a number of different applications that need different representations, has to deal with graphic character data represented in different codes. For computer system interconnections graphic character data represented in different systems has to be interchanged. As noted above, if the data is completely generated, processed and interchanged in systems that use a single code, it is not necessary to identify the code used other than in a descriptive manner in appropriate documentation. When heterogeneous systems that use different codes interact with each other, it is necessary to identify the code in a manner that can be interpreted in each system without any ambiguity.

Each component of the code has an identifier (a component identifier) - an Encoding Scheme identifier (ESid), a Character Set identifier (CSid), a Code Page identifier (CPid) (note CSid and CPid are in pairs), an ACRI definition (ACRI-xx). These component identifiers are defined in various documents (for example, IBM SAA Code Page Architecture), (SAA is a Trade Mark of International Business Machines Corporation). The complete code identification consists of a potentially lengthy list of these various component identifiers. Thus, especially when a variable length identifier cannot be handled, or is not efficient, (for example, tagging a column in a data base), a short form identifier is eminently desirable.

Known methods of identifying a code include:

* Use of a descriptive form such as "VideotexString" (in ISO 8825 - Abstract Syntax Notation ASN.1), "Mixed SBCS/DBCS PC Data" in Korea, "ASCII," "ISO 8859-2" (SBCS and DBCS stand for single byte and double byte coded character sets, respectively).

* Use of a numeric local identifier (LID), which acts as a pointer to a definition of the components in an accompanying description is to be found in some IBM architectures. For example, in one IBM system, a LID is used to point to a "map resource" which details the associated Character Set identifier, Code Page identifier, and other information needed for printing.

A method currently implemented in several IBM products uses a code page identifier alone. Examples are provided by products such as IBM PC DOS and OS/2 and IBM GDDM, (OS/2 and GDDM are Trade Marks of International Business Machines Corporation). The 16 bit size of CCSid is the same as the 16 bit size of the IBM defined CPid (specifically defined as Code Page Global Identifier or CPGid). The CCSid can be accommodated in the same field length as the CPid.

Up to the maximum value of 4095, whenever the associated encoding scheme and the character set associated with the code page can be unambiguously determined, the value of the CPid can be used directly for the CCSid, without losing the semantics behind the identifier. In other instances, a related CCSid value in the least significant 12 bits of the CCSid can be used. Such methods are time consuming and involve cumbersome processing.

Viewed from one aspect the present invention provides a method of codifying different encoding schemes used in the representation of graphic characters, comprising the steps of generating an identifier and allocating bits in said identifier to respectively represent individual identifiers used in said encoding schemes, to define in conjunction with a registry including the individual identifiers, required processing and interchanging information.

In a preferred embodiment of the invention described below, the identifier is chosen to be 16 bits in length.

The 16 bit CCSid value can be accommodated in one of the fields that is associated with the CSid or CPid. The alternative of having to provide additional fields for the missing component identifiers of the graphic character code can be eliminated.

Other advantages that are derived from the 16 bit binary number are:

* The size of the identifier is fixed at 16 bits. The fixed size facilitates optimizations when dealing with this identifier, compared with dealing with variable size non-numeric identifiers. The size of 16 bits is also one of the popular register lengths in most processors in use. The only potential complexity is due to byte reversals used in number representations in some computer hardware.

* Descriptive names can be associated with the CCSids in a customized manner, where there is such a need. Converting the binary number into a numeric string representation may suffice in most instances.

* The 16 bits are divided into two parts. These parts allow classification of codes that use the same CPids into related groups. The relationship may be, for example, using a sub-set or super-set character set within the code page, or using slightly different encoding schemes involving the same code page.

The present invention allows a single identifier supported by an appropriate identifier to identify coded character sets (codes) used for graphic character representation throughout the world today. It also permits any customized or experimental codes to be distinguished from the common ones. It allows implementing pro-

3

ducts to represent a large variety of graphic character codes using a single identifier.

In the preferred embodiment, the,"pointing" referred to above in connection with the use of local identifiers, is applied to the specific problem of graphic character code identification in the following manner:

* The code identifier is restricted only to the set of component identifiers required for graphic character representation, whereas the LID could point to almost any specific collection of global identifiers (including the CCSID itself).

* By allocating specific range of values for registration, this invention elevates the local identifier to a global identifier, thereby eliminating the need to carry the associated definition in the data stream for these registered values of code identifier.

* Retains the benefits of local identifiers by assigning a specific range of values for temporary use; at the same time provides a means to control the proliferation of registered code identifiers.

* Provides additional semantics to the code identifier.

The CCSID generated by the present invention is a binary number consisting of 16 bits. Being a binary number, it has the following properties:

* It can be represented in any computer system in internal data structures as a 16 bit binary pattern or two 8 bit bytes. It can be interchanged directly using any data stream architecture that supports bit or byte transparency. If bit or byte transparency is not supported, the binary pattern can be transformed to and from other suitable forms similar to any other binary number for interchange purposes.

* Unlike graphic character string identifiers, there is no need to specify the graphic character code used to represent this identifier itself.

Migration from existing identification methods is facilitated. The short form identifier produced by using the present invention consists, as noted above, of only 16 bits wherein each bit or group of bits can be so chosen as to represent the more complex, individual CS, CP and ACRI, etc., codes.

The short form identifier in the form of a Coded Character Set Identifier (CCSid), has the following capabilities:

* Acts as a short form (alias) for its corresponding list of component identifiers.

* Acts as a short form for a collection of specific component identifiers having a specific property.

* Allows special meanings to be conveyed in relation to tagging of data with the code identification.

* Allows bridging to existing systems that use only some components of the code identification.

In order that the present invention will be understood a preferred embodiment thereof will now be described by way of example only.

## CODED CHARACTER SET IDENTIFIER

A Coded Character Set Identifier, CCSid, is a 16 bit number that:

* Is a short form identifier having the same semantics as a specific set of elements of the long form identifier (for example, CCSid 00500).

* Or, has a predefined semantic that is common to a large number of long form identifiers (for example, CCSid X'F100' represents an IBM global use set).

* Or, has a predefined semantic not representable in the long form (for example, CCSid X'FFFF', which indicates the data is not coded graphic character data.

Bit Allocations in Coded Character Set Identifier

```
|<--  1st Byte   -->|<--  2nd Byte -->|
| 0 1 2 3 | 4 5 6 7 | 0 1 2 3 4 5 6 7 |


   ┌───────────┬─────────────────────────────┐
   │           │                             │
   └───────────┴─────────────────────────────┘
         │              │
         │              │
         │              └─────────> 12 bits
         │                          Sequence Numbers: 000 to FFF
         │
         │
         └──────────────────────────> 0 to D - for originator's
                                               use.
                                          E - for private/
                                               customer use.
                                          F - for special
                                               purpose use.
```

CCSid is used where a fixed length tag field is available or preferred, avoiding the problems associated with variable length aspect of the long form identifier. Some current methods use a CP identifier only. Such methods can be easily migrated to reliable identification via CCSid.

The range of CCSid values is X'0000' to X'FFFF' (0 to 65535 decimal). Also, today's users of Coded Graphic Character Set Global Identifiers (CGCSGids) may find it easier to migrate to CCSid than to provide extensions to handle the variable length long form identifier.

Code Page Architecture (CPA) documentation will include a registry of CCSid values. The bit allocations in a CCSid are shown below, and the CCSid values are allocated as shown immediately following:

Allocation of CCSid Values

| VALUE | PURPOSE/MEANING |
|---|---|
| X'0000' | Inheritance - This value is reserved to indicate that the value of CCSid is defaulted and to be taken from the next higher level in a defined hierarchy. This value cannot be used if there is no hierarchy or there is no higher level to default to. The highest level in the hierarchy cannot use these values. |
| X'0001' to X'DFFF' | Originator's Registered CCSids - These values are for originator's use. They can be registered and published in the CPA documentation. |
| X'E000' to X'EFFF' | Customer Defined CCSids - These values are reserved for customer-defined use. Customers must maintain their own organizational registries. |
| X'F000' to X'F0FF' | Not Allocated. |
| X'F100' to X'F1FF' | Global Use - These values are reserved for global use common character sets, such as the syntactic character set, associated with specific encoding structures. This avoids having to issue specific CCSids for usage of these character sets with every code page registered. |
| X'F200' to X'FEFF | Temporary or Local Use - These values are reserved to indicate that an associated long form identifier must be used, instead of a registered CCSid. These values can be used to indicate up to 3328 associated long form identifiers. These values act as local identifiers and specific instances of their use cannot be registered in CPA. If the long |

forms are exchanged between two entities the same CCSids can be used to refer to the corresponding long forms by the two entities. These values are expected to be used typically in situations which are self contained and where there is no need for

Allocation of CCSid Values (cont'd)

VALUE      PURPOSE/MEANING
           global understanding of the short form identifiers being used.
X'FFOO'to  Not allocated.
X'FFFE'
X'FFFF'    CCSid is Not Applicable - this value is reserved to indicate the CCSid is not applicable to the associated data. The associated data is not coded graphic character data.

ELEMENTS OF CHARACTER DATA REPRESENTATION

The following identifiers are associated with graphic character representation:
* Graphic Character Global Identifier
* Long Form Identification - a set of identifiers consisting of:
   − Encoding Scheme Identifier
   − One or more pairs of a graphic Character Set global identifier and a Code Page global identifier
   − Additional Coding related Required Information as specified by the Encoding Scheme identifier (for example: a list of valid first bytes of double byte code points, code points used for code extensions, or a set of floating accents and a valid associated character).
* Short Form Identification - an identifier, called Coded Character Set Identifier is defined as an alternative to the variable length long form.
These identifiers are defined below.

GRAPHIC CHARACTER GLOBAL IDENTIFIER

A Graphic Character Global identifier, GCGid, is a 4 to 8 character alphanumeric identifier assigned to a graphic character. It is semantically equal to the term "meaning of a graphic character". Each graphic character that is to be assigned a code point must have a GCGid.

The GCGid is used wherever a graphic character is referenced in a code independent manner. It is also the basis of establishing relationships between code points in different representations.

The GCGid assigned to each graphic character and the system used to derive and assign it can be defined in a suitable registry.

In CPA, the terms Graphic Character identifier, Character identifier, and Meaning of Graphic Character are synonymous with GCGid

LONG FORM IDENTIFICATION

The long form identification consists of an Encoding Scheme identifier, one or more sets of Character Set and Code Page identifiers, and any Additional Coding related Required Information that is required to complete the specification of the representation.

ENCODING SCHEME IDENTIFIER

The Encoding Scheme identifier, ESid, is a 4 digit hexadecimal number containing the specification of the following three components of the scheme used to code graphic character data:
* Basic coding structure - This component distinguishes between different basic systems of coding such as EBCDIC, ISO 8, IBM PC Data or others.
* Number of bytes per code point - When the coding system permits a different number of 7 or 8 bit bytes per code point (for example, 7 bit ASCII), this component identifies the selection used.
* Code extension method used, if any - This component identifies the particular method of code extension used from among the many that may be allowed in the encoding system.
Below is shown the structure used by CPA to assign values to the various elements of ESid. The ESid value is a composite of the element values. The element values and their meanings are detailed in the following sections.

The encoding scheme identifier allows the selection of the correct process to be invoked to work with graphic character data. It also determines the number and types of other identifiers needed in the long form.

Encoding schemes reserve code point(s) for allocation to some most frequently used characters such as SPACE (GCGid SP010000).

Encoding schemes also reserve code points for a small collection of graphic characters, such as the Syntactic Character Set in EBCDIC. When these characters are part of a character set in use, the code points assigned to this collection are defined to be invariant.

Encoding Scheme identifier Format

```
|<--  1st Byte   -->|<--  2nd Byte -->|
| 0 1 2 3 x 4 5 6 7 | 0 1 2 3 4 5 6 7 |


  ┌──────────┬───────┬──────────────────┐
  | 0 -- F   | 0 -- F |    00 -- FF      |
  └──────────┴───────┴──────────────────┘
       |         |         |
       |         |         |
       |         |         └─────────> Code Extension Method
       |         |
       |         └──────────────────────> Number of Bytes Indicator
       |
       └──────────────────────────────────> Basic Encoding Structure
```

BASIC ENCODING STRUCTURE

The following values are defined to identify exemplary structures

| HEX | STRUCTURE |
|-----|-----------|
| 0 | Defaults to higlier level in hierarchy |
| 1 | EBCDIC |
| 2 | IBM PC Data |
| 3 | IBM PC Display |
| 4 | ISO 8 |
| 5 | Reserved for ISO 7 |
| 6 | Reserved for FOCA Presentation Code Page Structure |
| 7 to D | Reserved for future allocation by CPA |
| E | Reserved for extending ES id, when needed |
| F | For private use. Use of this value must be accompanied by a specification of the structure, and the values and the semantics of use |
| HEX | STRUCTURE |
| | of the other parts of the Encoding Scheme identifier with which it can be used. |

NUMBER OF BYTES INDICATOR

An encoding scheme may permit specific variations from the basic structure for the number of bytes associated with a code point. These variations are indicated using the second nibble (a nibble is four bits, or half a byte) of the Encoding Scheme identifier. The value of this nibble is only a pointer to definitions, its value does not equate to the number of bytes in the code point. The values representing variable numbers of bytes only show what can potentially appear in a string, not what may actually appear. The encoding scheme defines permitted values of this nibble that are permitted for the encoding structure used.

If the value of the first nibble defining the basic structure element is zero, the second nibble identifying the number of bytes must also be zero.

HEX     NUMBER OF BYTES PER CODE POINT

| HEX | NUMBER OF BYTES PER CODE POINT |
|---|---|
| 0 | Reserved for use with zero value for the structure element |
| 1 | Fixed single byte character set |
| 2 | Fixed double byte character set |
| 3 | IBM Far East style, mixed single byte or double byte character set |
| 4 | Reserved for ISO 2022 Multiple Byte |
| 5 | Reserved for ISO Multiple Octet (ISO 10646) |
| 6 | Reserved for ISO 6937 style, single byte or double byte, Non Spacing (see section A.2.6, "ISO Codes with Non-Escaping Characters") |
| 7 to E | Reserved for future allocation by CPA |

HEX   NUMBER OF BYTES PER CODE POINT

| HEX | |
|---|---|
| F | Private Use |

The specification of Private Use must include the values and the semantic of use of the encoding structure nibble with which it can be used.

## CODE EXTENSION METHOD

The code extension method is described by the second byte of the ES identifier. This byte only indicates that a code point from an extended coded character set may appear in the data; it does not indicate that the extension method has actually been used in a specific character string. The value of each of the first two nibbles of the Encoding Scheme identifier that can be used with the values defined below must be non-zero.

The following values are defined

| HEX | CODE EXTENSION METHOD |
|---|---|
| 00 | No extensions are specified |
| 01 | Locking Shifts (SO and SI, or LSI and LSO) |
| | NOTE: Other values are reserved by CPA |
| 02 to FD | Reserved for future allocation by CPA |
| FE | Reserved for Private Code Extension Use |
| FF | Code Extensions consideration does not apply |

## GRAPHIC CHARACTER SET GLOBAL IDENTIFIER

A Graphic Character Set Global identifier, GCSGid, may be a 5 digit decimal identifier assigned to a graphic chararter set. Each collection of characters that is to be processed as an entity is called a graphic Character Set.

The GCSGid uniquely identifies a specific collection of GCGIDs that are valid in the set.

The range of GCSGid values is "00001" to "65534" or the hexadecimal equivalent of X'0001' to X'FFFE'. The value 00000 cannot be assigned to any character set: it is reserved by CPA for implementations to indicate that the GCSGid value is to be inherited from a higher level in a hierarchy. The values X'FE00' to X'FEFF' are reserved for request for price quotation (RPQ) use on IBM products. The values X'FF00' to X'FFFE' could be reserved for customer use. The value 65535 (X'FFFF') could be reserved in a registry for future assignment.

By itself, the GCSGid does not specify either the inclusion or exclusion of the SPACE character. Each encoding scheme reserves one or more code points for allocation to the SPACE character. There are potentially two possible code points for it when using mixed SBCS and DBCS encoding schemes.

## CODE PAGE GLOBAL IDENTIFIER

A Code Page Global identifier, CPGid, is a 5 digit decimal number assigned to a code page.

In the broad sense, a code page is a specification of code points for each graphic character in a character set, or in a collection of graphic character sets. Within a given code page, a code point can have only one specific meaning.

A CPGid identifies a unique assignment of the graphic code points in an encoding scheme to a specific set of GCGids representing graphic characters. This collecting of GCGids is also registered with a GCGid, and is the maximal graphic character set associated with the code page. Often, when a code page is first created and registered, some of the assignable graphic code points may not have assigned GCGids. Therefore, the maximal set need not be a full graphic character set of the code page.

Also, the same CPGids have been used when the encoding structures are similar but not identical.

The range of CPGid values is "00001" to "65534" or the hexadecimal equivalent of X'0001' to X'FFFE'. The value 00000 cannot be assigned to any code page; it is reserved by CPA for implementations to indicate that the CPGid value is to be inherited from a higher level in a hierarchy. The values X'FE00' to X'FEFF' are reserved for request for price quotation (RPQ) use on IBM products. The values X'FFOO' to X'FFFE' could be reserved for customer use. The value 65535 (X'FFFF') could be reserved in a registry for future assignment.

## CODED GRAPHIC CHARACTER SET GLOBAL IDENTIFIER

Coded Graphic Character Set Global identifier, CGCSGid, is a concatenation of the Graphic Character Set Global identifier with (followed by) the Code Page Global identifier.

CGCSGid identifies a specific collection of graphic characters and their assigned code points using an encoding scheme. Many architectures and supporting implementations in SAA Coded Character Set, such as Document Interchange Architecture (DIA) have traditionally supported the CGCSGid. It has been assumed that the encoding scheme information can always be reliably derived from the code pages. It will also not be valid if schemes such as the mixed single byte and double byte encodings used in the Far East, or the single shift code extension mechanism used in the IBM RT PC, have to be represented.

The term GCid used in some IBM architectures is synonymous with CGCSGid.

## ADDITIONAL CODING RELATED REQUIRED INFORMATION (ACRI)

Some encoding schemes require specifications beyond the CS and CP elements.

For example, one type of ACRI is defined. Others may be needed with other ES ids in the future

## ACRI-PCMB

ACRI-PCMB (standing for PC Mixed Byte) is particular to ES values X'2300' or X'3300'. It is not specified with any other ESids and consists of a specification of ranges of valid first bytes of double bytes associated with particular CS, CP pairs that are used with this encoding scheme. An ACRI-PCMB has the following format:

N, From-Byte 1, To-Byte 1, From-Byte 2, To-Byte 2,....
From-Byte N, To-Byte N

where N is the number of ranges, From-Byte and To-Byte are the starting and ending bytes of each range of valid first bytes.

## DATASET TAGGING

Tagging is the primary means to identify the meaning of coded graphic characters. It is the method by which one or more CPA identifiers can be associated with a coded graphic character in a data object such as a file, database table or data stream; by which the graphic character handling capability of a device (such as a display terminal) can be identified or selected; and by which the graphic character handling capability associated with a piece of processing logic can be identified.

When data is tagged, for example with CCSids, the GCGids assigned to the graphic character code points are in accordance with the definition of CCSids.

When a graphic character is represented using a CCSid tag:

* It is in one of the character sets identified by the CS elements associated with the CCSid.

* It has a code point assignment in the code page identified by the CP element (corresponding to the above CS) associated with the CCSid.

* The number of bytes in the code point will be as per the encoding structure identified by the ESid element associated with the CCSid.

* The encoding scheme also prescribes if and when any code extension controls have to be inserted in a string of code points representing graphic character data.

* If a graphic character is coded more than once, any one of the assigned code points can be used. The selection will be arbitrary, unless some application-specific criterion is used.

When data is to be interpreted according to a tag value:

* Parsing associated with the ESid element of CCSid tag is needed. This logic will isolate the number of bytes for each code point in the data to be interpreted.

* If the code point is in the graphic character coding space of the encoding structure, it is checked for an assigned GCGid in the code page identified by the appropriate CPGid element of CCSid.

* The GCGid, if one is found, must be contained in the set of characters identified by the appropriate GCSGid element of CCSid, before the GCGid can be used as the graphic character associated with the data.

If the parsing process cannot isolate a code point reliably, if a GCGid cannot be found, or if the GCGid is not part of the set identified by GCSGid, then data does not have a graphic character meaning.

SYSTEM SERVICES

This disclosure describes services that are needed to support the identifiers and to consistently manage different representations of graphic character data. Programs that implement a service are deemed providers of that service, while another program or an end-user using that service is an invoker. For example, a graphic character conversion program is a provider of the conversion service, while an application that calls that program is an invoker.

Support functions are related to tagging of data objects. Each of these support functions may be grouped into functions that are needed to assist in graphic character data processing, and functions that are needed to define and maintain the supporting resources. These are identified in the following descriptions.

FUNCTIONS RELATED TO TAGGING

Tag related functions either enter or read CCSid values from tag fields, operate on the long or short form of CPA identifiers, assist in finding relationships between CCSids and their elements, or assist in maintaining CCSid resources that define the different elements associated with each CCSid. Brief descriptions of each of these functions follow:

SETTING TAG VALUES - Setting is the process of entering one or more tag values into the tag fields associated with different graphic character data elements. The set function is provided as part of the various object manager specific interfaces, or associated service functions. Setting of tag fields on entities owned by the operating system is provided by the system-specific interfaces. Setting may be performed only at the time of creating the objects - such as files or databases and may be provided as part of the object creation function.

QUERYING TAG VALUES - Querying is the process of reading or finding out one or more tag values associated with graphic character data elements. The query function is provided as part of various object-manager specific interfaces, or associated service functions. Querying of tag fields in entities (or objects) owned by the operating system is provided by services in the operating system, as part of the system-specific services.

This function has the capability to resolve any unknown or default values associated with CCSid value of X'0000'. Any hierarchy used for organizing the different elements owned by the object managers are object manager specific. Different types of queries are applicable to different object managers. For example, a file manager may provide for querying all the CCSids that are encountered within a file; a presentation manager may provide for querying the CCSID used in a currently active window.

To assist in resolving the defaults in a hierarchy, a function to enter default values (register) for an application, a user or another module, either on a static basis or dynamically changeable basis may be provided. This registry (called a CCSid Defaults Registry) is a system specific resource.

FINDING SUPPORTED CCSids - A particular object manager implementation or system installation may elect to support a list of CCSids. Also, different levels of support may be provided for each of these CCSids. In order to match the capabilities of an object manager with the requirements of an application, it is necessary to find out which CCSids are supported and to what extent, The type of support assists in deciding whether the data can be processed as it is, if it can be processed with some additional processing step, or if it cannot be processed at all.

Three levels of support are defined:

* FULL SUPPORT:

The CCSid is recognized, and the object manager can process the data respecting the GCGid associated with the code points. Data can be sent or received from an object manager in any one of such fully supported CCSids. Within this collection of CCSids, any graphic character data conversions will be performed automatically, transparent to the user of the object manager's services. Full support for a CCSid means that all the associated resources needed to process data encoded in that particular CCSid are in place. The interpretation of full support also depends on the object-type. For example,

* for a device manager, full support for a CCSid means that the application can use that CCSid for data sent to the device manager and expect the data in that CCSid from the device manager

* for a data-object manager, it means that data represented in that CCSid can be sent to or received from that object manager by an application. In the event difference management action is needed, it will be transparently supported between all the fully supported CCSids

* for an application, it means that processing logic in the application can process data in any one of the CCSids that is listed as fully supported. The application may have specific processing logic either to handle the data using these CCSids, or to handle the data after transparently converting it to one of the fully supported CCSids.

* RECOGNITION SUPPORT:

In addition to the fully supported CCSids, there may be a list of CCSids for which resources needed for conversion are available in the system environment, but the data encoded in them must be converted to a fully supported CCSid before the object manager's services can be used. The CCSid is recognized, but data cannot be stored or processed by the object manager directly in it. The data must be converted to one of the fully supportel CCSids. Also, a conversion service is available somewhere in the system so that data can be converted to or from one or more of the fully supported CCSids.

* UNRECOGNIZED:

All other CCSids are not recognized in that component. Tolerance to data tagged with such CCSids may be provided by some object managers such as a file manager. Depending on the object being managed, pass-through capability may be possible.

Two related functions are defined:

* Check the level of support for a given CCSid - This function returns the level of support provided in an object manager for a given CCSid.

* Given a level of support find the list of CCSids - This function provides a list of CCSids supported at a specified level of support in an object manager.

Accuracy of the CCSid values in the resources supporting this function is based on the documentation on CCSids supported, and on whether customer-defined or temporary CCSids are supported.

RELATING SHORT AND LONG FORMS

LOOKUP A LONG FORM GIVEN A SHORT FORM - SHORT TO LONG: this function gets the set of elements that constitute the long form associated with a CCSid value from the CCSid resource repository. The specified CCSid value (CCSidl) must have an entry in the CCSid resource repository. The long form return is the associated entry in the repository for CCSidl.

LOOKUP A SHORT FORM GIVEN A LONG FORM - LONG TO SHORT: this functions gets the CCSid value associated with a set of elements expressed in the long form from the CCSid resource repository. The long form being converted must exist in the CCSid resource repository. The CCSid value return is the corresponding entry in the repository for the long form specified.

ADD A CCSid RESOURCE - This function adds a new CCSid and its associated elements to the CCSid resource repository. The function checks if an entry for the specified CCSid value already exists in the CCSid resource repository in order to prevent the addition of duplicate entries. The input elements to be added are expected to be valid with respect to the CPA definition of the elements. It is the responsibility of the caller of this function to maintain this validity.

DELETE A CCSid RESOURCE - This function deletes a CCSid and its associated elements from the CCSid resource repository.

GET LONG FORM TEMPLATE - This function gets a template of the long form to be used to fill in the entries. A collection of standardized templates for known ES values is available. The returned template will indicate which elements are mandatory, and how many elements of the template are needed. All the elements that are not applicable to this particular ES value are pre-filled to "null" equivalent. The invoker changes the appropriate entries in the template to create a CCSid and its equivalent long form.

GET RELATED CCSids (Type 1) - This function provides a list of all CCSids in the CCSid resource repository that satisfy the specified relationship (type 01) to a given CCSid value (specified in the input variable CCSid1). The relationship of type 01 is defined below, in terms of what the function has to do.

This function first verifies that the value of CCSid1 is in the CCSid resource repository. It then searches the repository for other CCSid values, which have at least one of the pairs of values of CSid, CPid in common with the values of CSid, CPid pairs associated with the input CCSid1 value. If there is more than one pair of CS, CP values associated with CCSid1 value, then a match of at least one pair of CS, CP values results in a CCSid value being added to the output CCSid list. The list of CCSids generated in this list have a relationship of type 01 to the value in CCSid1.

A further filtering of the CCSid list can also be specified. If the ES filter value is other than 0, then this ES value is used for additional matching. In this case, the matched CCSids must also have the same ES value as specified in the filter. If the ES filter value is 0, filtering is not requested. If none of the CCSids in the list has an associated ES filter value that equals the ESF value, the unfiltered list of CCSids will be returned along with a non-zero return code value.

CONVERT A GRAPHIC CHARACTER DATA STRING - This function converts a graphic character data string of the identified string type represented in a specified "from" CCSid (in CCSid1) to a graphic character data string of the required string type tliat is represented in another specified "to" CCSid (CCSid2).

To perform the conversion, a (CCSid1, ST1) to (CCSid2, ST2) entry must exist in the Graphic Character Conversion Selection Table (GCCST) along with the conversion method and conversion table(s). An installation may need to support more than one conversion method or conversion table(s) from a given (CCSid1, ST1) to (CCSid2, ST2). Each of these alternatives must have an entry in the GCCST. The Graphic Character Conversion Alternative Selection Number (GCCASN) differentiates the entries for a given (CCSid1, ST1) to (CCSid2, ST2) from each other.

NOTE: The GCCASN is not to be confused with the options used in creating the conversion tables following different criteria for mismatch management, it is used for selecting the appropriate conversion method and associated table(s). There is no correspondence between the GCCSAN and the mismatch management criterion used in creating the conversion table(s) except by originator defined or user defined conventions.

RELATIONSHIPS BETWEEN CCSids - When an environment deals with multiple encoding schemes (such as PC Data and PC Display in the OS/2 environment, or the pure single byte or mixed single byte and double byte codes in systems supporting Group 2 character sets) special query functions are needed to find different CCSids that have specific relationships between them.

## DIFFERENCE MANAGEMENT FUNCTIONS

Computer environments use different graphic character sets and codes. The differences exist because of reasons like origin of the operating system, support of National Languages in different countries, or specific application requirements. Implementing character sets for different groups is an approach to minimize differences that must be dealt with. However, the differences cannot be completely eliminated. Therefore, one of the key challenges is the ability to deal with these differences in a consistent manner.

Difference management is the process that detects and deals with differences between graphic character processing capabilities or representations of data. Different-detection mechanisms placed at appropriate places in a system design determine if differences exist.

Any difference between data representation and processing capability triggers difference management action. The query function assists in finding tag values to decide if there is difference between two entities. The action may be one of:

* Do not convert the data, where possible;
* Convert the date, where possible; or
* Abort

DO NOT CONVERT - A "do not convert" decision may be taken in the following circumstances:

– A processing logic or a resource that can process the data correctly is available and can be selected.
– There is need to keep the data as is without losing the tag value associated with it, especially when the context of use is simply store and retrieve. Note that this may not always be feasible in that a receiving data storage manager may have restrictions on the CCSid(s) that can be used with the data that is stored in it.

* The needed data conversion resources are not in place. In this case, the "do not convert" decision is made by a conversion function after the invoker calls the conversion function, but that conversion function cannot convert the data.
* The conversion options available are not satisfactory in that data loss or pollution encountered would be unacceptable.

When a service provider takes on the role of deciding whether to convert or not to convert on behalf of an invoker of that provider, the invoker should be able to communicate to the service to bypass any conversions performed by the service.

CONVERT - Converting between different coded sets involves dealing with character-set mismatches while preserving character integrity for the largest set of characters. During a conversion, only the common set of graphic characters between different sets can theoretically be preserved. Managing the mismatched characters depends on the nature and context of use of the data.

Mismatch handling can generate converted data that may not have an assigned graphic character meaning in the output. such pollution of graphic character data may or may not be acceptable to a given application.

To deal with different possible contexts of use and the associated pollution control needed, CPA defines a few criteria for mismatch management. These criteria are reflected in the contents of conversion tables that are used in the conversion process. CPA defines a set of tables for specific pairs of CCSids to provide consistency among IBM product implementations, following the most appropriate criterion for that pair of CCSids.

One of CPA's goals is to minimize the loss of graphic characters during a conversion. The SAA Character Sets aid in maximizing graphic character integrity within a group or subgroup. Coding differences within a group can also be minimized (although not eliminated completely) over a period of time.

A comprehensive method has been described for codifying the different encoding schemes that are used for graphic character representation, resulting in a single identification mechanism that is used in conjunction with a corresponding registry to simply and uniquely identify the scheme used.

## Claims

1. A method of codifying different encoding schemes used in the representation of graphic characters, comprising the steps of:

    generating an identifier and allocating bits in said identifier to respectively represent individual identifiers used in said encoding schemes, to define in conjunction with a registry including the individual identifiers, required processing and interchanging information.

2. A method as claimed in Claim 1 wherein said identifier comprises a predetermined number of bits for indicating the origin of the encoding scheme and a predetermined number of bits for indicating sequence number, thereby uniquely identifying the encoding scheme.

3. A method as claimed in any of Claims 1 or 2 wherein said identifier comprises a predetermined number of bits for indicating the encoding structure, a predetermined number of bits for indicating a number of bytes and a predetermined number of bits for indicating code extension method, thereby specifying the processing functions to interpret graphic character data.

4. A method as claimed in any of the preceeding claims wherein said identifier is used in tagging a data object comprised of one or more of said graphic characters, to represent said data object, and further including the steps of identifying the graphic character handling capability associated with a device and inserting said identifier into said data object thereby permitting the accurate definition of said graphic characters.

5. A method as claimed in any of the preceeding claims wherein said identifier is used in tagging a data object, comprised of one or more of said graphic characters, for interpreting said data object, and further including the steps of parsing said data object for isolating said identifiers from a data object comprised of said graphic characters, decoding said predetermined bits and thus reliably determining said graphic characters.

6. A method as claimed in any of the preceeding claims wherein said identifier is 16 bits in length.

7. A data processing system including means for codifying different encoding schemes used in the representation of graphic characters, comprising:
    means for generating an identifier and allocating bits in said identifier to respectively represent individual identifiers used in said encoding schemes;
    a registry including said individual identifiers; and
    means for defining in conjunction with said registry, required processing and interchanging information for said graphic characters.